# EUROPÄISCHE PATENTSCHRIFT

(11) **EP 0 535 522 B1**
(45) Veröffentlichungstag und Bekanntmachung des Hinweises auf die Patenterteilung: **18.12.1996**
(21) Anmeldenummer: 92116254.1
(22) Anmeldetag: 23.09.1992
(51) Int. Cl.: H01L 31/18, H01L 31/072, H01L 31/0224

(54) **Verfahren zur Herstellung von pn CdTe/CdS-Dünnschichtsolarzellen**
Method to produce pn CdTe/CdS thin film solar cells
Procédé pour fabriquer des cellules solaires à couches minces du type pn CdTe/CdS

(30) Priorität: 03.10.1991 DE 4132882
(43) Veröffentlichungstag der Anmeldung: 07.04.1993
(73) Patentinhaber: ANTEC Angewandte Neue Technologien GmbH, D-65779 Kelkheim (DE)
(72) Erfinder: Bonnet, Dieter, Dr., W-6382 Friedrichsdorf (DE); Henrichs, Beate, W-6236 Eschborn (DE); Jäger, Karlheinz, W-6242 Kronberg (DE); Richter, Hilmar, Dr., W-6000 Frankfurt am Main 60 (DE)
(74) Vertreter: Reichel, Wolfgang, Dipl.-Ing.

(56) Entgegenhaltungen:
- EP-A- 0 006 025
- US-A- 4 375 644
- US-A- 4 650 921
- JOURNAL OF VACUUM SCIENCE AND TECHNOLOGY : PART A, Bd. 8, Nr. 2, März 1990, New York US, Seiten 979-983; V. SOSA et al.: 'Pressure and temperature influence on CdTe thin-film deposit by close-spaced vapor transport technique'
- SOLAR CELLS, Bd. 21, Juni 1987, Lausanne CH, Seiten 73-80; T.L. CHU et al.: 'Thin film cadmium telluride solar cells'
- JAPANESE JOURNAL OF APPLIED PHYSICS, Bd. 29, Nr. 10, Oktober 1990, Tokyo JP, Seiten 2003-2007; H. UDA et al.: 'Effect of Substrate Temperature on the Photovoltaic Properties of a CdS/CdTe Solar Cell'
- CONFERENCE RECORD OF THE 22ND IEEE PHOTOVOLTAIC SPECIALISTS CONFERENCE, Bd. II, 7. November 1991, Las Vegas US, Seiten 1165-1168; D. BONNET et al.: 'High-rate deposition of high-quality CdTe films for high-efficiency solar cells'
- SOLAR CELLS, Bd. 23, Januar 1988, Lausanne CH, Seiten 19-29; Yuan-Sheng TYAN : 'Topics on thin film CdS/CdTe Solar Cells'

## Beschreibung

Die vorliegende Erfindung betrifft Verfahren zur Herstellung von polykristallinen pn CdTe/CdS-Dünnschichtsolarzellen und insbesondere solche Verfahren, die eine kostengünstige Massenproduktion ermöglichen.

Aufgrund seiner günstigen Energielücke von 1,45 eV eignet sich CdTe ideal als photoaktives Material für Solarzellen. Außerdem können polykristalline Schichten von wenigen µm Dicke mit unterschiedlichen Verfahren (physikalisches bzw. chemisches Verdampfen/Sublimieren im Vakuum, galvanische Abscheidung Siebdruck, Sprühverfahren) hergestellt werden, die im allgemeinen zur Verbesserung ihrer elektronischen Eigenschaften einer chemisch-thermischen Nachbehandlung (R.W. Birkmire et al, Proc. Polycrystalline Thin Film Programm Meeting, Lakewood, Colorado, USA, 1989) 77-84) zu unterziehen sind. Diese beiden Eigenschaften machen CdTe zu einem der interessantesten Kandidaten für kostengünstige Dünnschichtsolarzellen.

Zum ersten Mal kam CdTe um 1960 zum Einsatz in Dünnschichtsolarzellen. Ende der 70iger Jahre wurden für solche Solarzellen Wirkungsgrade um 9% berichtet. Z.B. beschreibt die US-PS 4 207 119 (Yuan-Sheng Tyan, 1980) eine CdS/CdTe-Solarzelle mit Sauerstoff als Dotierung in beiden Halbleiterschichten CdS und CdTe der Zelle. Nachteilig erweist sich hierbei die Verwendung von Sauerstoff während der Schichtherstellung, da es bei zu hoher Sauerstoffkonzentration in der Abscheidekammer leicht zur Oxidation der CdTe-Quelle kommen kann, wodurch der Abscheideprozeß gestört bzw. sogar unterbrochen wird. Außerdem beträgt die Temperatur des Substrates, auf dem die polykristalline CdTe-Schicht abgeschieden wird, mindestens 515 °C und es werden teure temperaturbeständige Glassubstrate (mit Erweichungstemperaturen von 650 bis 700 °C) verwendet. Unterhalb einer Substrattemperatur von 575 °C wurde eine signifikante Abnahme des erzielbaren Wirkungsgrades festgestellt. Hierzu wurde die CdTe-Schicht in einer sauerstoffhaltigen Atmosphäre versuchsweise bei niedrigeren Temperaturen bis hinunter zu 500 °C abgeschieden, wobei sich jedoch ein Wirkungsgrad von weniger als 4% ergab. Ferner wurde die Möglichkeit vorgeschlagen, den Wirkungsgrad durch zusätzliche Sauerstoffnachbehandlung um 1 bis 2% zu erhöhen, wodurch sich allerdings bei 500 °C erst Werte um maximal 6% ergeben würden. Es wurde auch versucht, die CdS-Schicht im Gegensatz zur CdTe-Schicht sauerstoffrei abzuscheiden. Die Versuche ergaben jedoch, daß die CdS-Schicht ebenfalls in einer sauerstoffhaltigen Atmosphäre abgeschieden werden muß, um bei Substrattemperaturen über 575 °C einen Wirkungsgrad von bis zu 8,9% erzielen zu können. Es wurden in den durchgeführten Versuchen 0,5 µm dicke CdTe-Schichten in 2 min abgeschieden. Bei einer aus physikalischen Gründen erforderlichen Mindestdicke von etwa 2 bis 3 µm, sind bereits etwa 10 min für die Abscheidung erforderlich.

In der US-PS 4 650 921 (Kim W. Mitchell, 1987) ist eine pn CdTe/SnO₂-Dünnschichtsolarzelle beschrieben, bei der die polykristalline CdTe-Schicht ebenfalls bei hohen Substrattemperaturen (600 - 650 °C) abgeschieden wird, wobei ebenfalls die üblichen teuren temperaturbeständigen Glassubstrate eingesetzt werden. Es wird zunächst die CdTe-Quelle bis auf 600 °C aufgeheizt und bei Erreichen dieser Temperatur das bis dahin auf 450 °C aufgeheizte Substrat schnell auf 650 °C hochgeheizt. Die CdTe- Abscheideraten zur Erzielung einer etwa 10 µm dicken CdTe-Schicht im CSVT-Verfahren (Close Space Vapour Transport) sind sehr gering und es muß etwa 20 Hinuten lang abgeschieden werden.

Auch in den folgenden Veröffentlichungen wird stets ein teures Substratmaterial in Form von Borosilikatglas, speziell Corning 7059 Glas oder Pyrex eingesetzt, das einerseits die erforderliche Temperaturstabilität für die hohen Substrattemperaturen aufweist und andererseits speziell alkaliionenfrei für den Einsatz in photovoltaischen Einrichtungen entwickelt wurden.

In V. Sosa et al., J. Vac. Technol. A8(2) (1990) 979 wird das Abscheidungsverhalten des für CdTe-Solarzellen geeigneten Materials allgemein untersucht, wobei das Ziel war, die Gesetzmäßigkeit für die P- und T-Abhängigkeit der Sublimationsrate zu ermitteln. Um den Einfluß einer Druckvariation zu ermitteln, wurde u.a. auch einmal die Substrattemperatur auf 498 °C eingestellt, dann aber schrittweise erhöht und für mehrere Druckwerte die Sublimationsrate gemessen. Es wird direkt auf dem Pyrex- oder 7059 Corning-Glasabgeschieden. Der Fachmann weis, wie auch in Tl. L. Chu et al., Solar Cells 21 (1987) 73, auf S.78, letzter Absatz, ausgeführt ist, daß bei der Abscheidung der CdTe-Schicht eine Wechselwirkung zwischen dem CdTe und dem darunter liegenden CdS zu beachten ist und das Aufwachsverhalten von dem jeweils letzten Schichtmaterial wiederum empfindlich anhängt.

Ferner ist aus der letzgenannten Schrift entmehmbar, daß für den Wirkungsgrad der fertigen Zelle entscheidend die Schichteigenschaften (Kornstrukur und Widerstandsverhalten) sind. Weiterhin verwendet die letztgenannte Schrift wiederum das Corning 7059 - Glas als Substrat. Im Gegensatz zur CVD-Beschichtung mit vorteilhaft großen Korngrößen, jedoch niedrigen Abscheideraten werden bei der CSS-Technik gemäß Punkt 2.2 dieser letztgenannten Schrift zwar höhere Abscheideraten erzielt, jedoch kleine Korngrößen mit nicht unterscheidbaren Korngrenzflächen in der CdTe-Schicht. Dies führt dazu, daß der Widerstand so groß ist, daß ohne Dotierung der Schicht keine ausreichend niedrigen Widerstandswerte erzielbar sind.

In dem ebenfalls von Chu et al verfaßten Artikel Solar Cells, 23 (1988), Seiten 31 bis 48, ist dargestellt, daß die Korngrößen erst bei Substrattemperaturen über 550 °C verbunden mit einer merklichen Abnahme des Widerstandes ansteigen. Auf Seite 40 über Punkt 3.2 ist in dieser Schrift ausgeführt, daß die Abscheideraten vom sehr geringen Wert 0,6 µm min⁻¹ bei 500 °C Substrattemperatur auf den Wert 10 µmmin⁻¹ bei 600 °C steigen. Ferner ist nach den Figuren 12a und b dieser Schrift bei 600 °C erst die gewünschte Kornstruktur erzielbar. Dies schlägt sich auch im Widerstandsverhalten gemäß Fig.13 nieder, wobei auch hier erst in der Nähe von 580 °C bis 600 °C vernünftige Werte im Hinblick auf einen akzeptablen Wirkungsgrad erzielt wurden.

Dies entspricht den Aussagen des übrigen Standes der Technik, der weiter oben bereits gewürdigt wurde. Ferner wird in beiden obigen Schriften von Chu et al dargelegt, daß letztlich eine Dotierung der CdTe-Schicht erforderlich sei, um die gewünschten elektrischen Eigenschaften zu erzielen.

Neben diesen vakuumgestützten Abscheideverfahren wurden in den 80iger Jahren galvanische Methoden (z.B. B.M. Basol, Solar Cells, 23 (1988) 69-88; V. Ramanathan et al, Proc. 8th Photovoltaic Solar Energy Conf., Las Vegas, (1988) 1417-1421) sowie Siebdruck- (z.B. S. Ikegami, Solar Cells, 23, (1988) 89-105) bzw. Sprühverfahren (z.B. J.F. Jordan, Solar Cells, 23, (1988) 107-113) zur Herstellung polykristalliner CdTe-Schichten beschrieben.

Die galvanische Abscheidung geschieht aus einer wässerigen Lösung von CdSO₄ und Te₂O₃ bei Temperaturen von ca. 90 °C. Um Schwankungen der Stöchiometrie in der wachsenden CdTe-Schicht zu vermeiden, müssen sehr kleine und damit kostenungünstige Abscheideraten von nur etwa 1 µm/Std eingehalten werden.

Beim Siebdruckverfahren werden Aufschlämmungen aus Cd- und Te-Pulvern auf ein Substrat aufgebracht und mit hohem Materialverbrauch zu relativ dicken Schichten um 30 µm gesintert, wobei Cd und Te zu CdTe reagieren. Auch hier werden hohe Temperaturen von über 700 °C benötigt, was die Verwendung teurer Substrate bedingt.

Beim Sprühverfahren wird eine wässrige Lösung aus Cd- und Te-haltigen Verbindungen in Form eines feinen Tröpfchen-Aerosols auf ein ca. 400 °C heißes Substrat gesprüht. Die wachsende CdTe-Schicht neigt beträchtlich zu Porosität, so daß relativ dicke Schichten hergestellt werden müssen, um die notwendige Dichtheit der Schichten zu garantieren. Damit verbunden ist wiederum ein kostenungünstig hoher Materialverbrauch. Des weiteren ist dem Verfahren ein beträchtlicher Verlust an Sprühlösung dadurch inhärent, daß diese als feines Aerosol die gesamte Reaktionskammer ausfüllt und an den Wänden und über die Abluft verlorengeht, wodurch nur eine mäßige Materialausbeute der Cd- und Te-Verbindungen erreicht werden kann. Als besonders kritisch erweist sich beim Sprühverfahren die chemisch-thermische Nachbehandlung.

Der Erfindung liegt daher die Aufgabe zugrunde, ein verbessertes Verfahren für die Herstellung von pn CdTe/CdS-Dünnschichtsolarzellen anzugeben, das sich insbesondere für eine kostengünstige Massenproduktion eignet und die Herstellung zufriedenstellender Solarzellen ermöglicht.

Die erfindungsgemäße Lösung dieser Aufgabe gemäß Anspruch 1 beinhaltet ein völliges Abgehen von den bisherigen als notwendig erachteten hohen Substrattemperaturen, um Solarzellen mit Wirkungsraden um und vor allem über 10% herstellen zu können. So stellten die Erfinder überraschend fest, daß es möglich ist, zufriedenstellende Solarzellen mit hohem Wirkungsgrad gemäß dem Oberbegriff des Patentanspruchs 1 herzustellen, wenn dafür gesorgt wird, daß die Temperatur des mit der TCO-Schicht und der CdS-Schicht versehenen transparenten Substrats vor der CdTe-Beschichtung auf Temperaturen unter ca. 520 °C und oberhalb ca. 480 °C gebracht wird und die jeweilige Temperatur auch während der folgenden Beschichtung beibehalten wird. Dabei wird die CdTe-Schicht stets in einer Inertgasatmosphäre abgeschieden. Beim sauerstoffreien Arbeiten im Stand der Technik wurden durchgängig Substrattemperaturen von 600 °C und mehr angewandt.

Ferner wird erfindungsgemäß das preisgünstige Standard-Natron-Kalk-Glas in Form von Fensterglas als Substratmaterial verwendet, das bei allen getesteten Ausführungsbeispielen Solarzellen mit hohem Wirkungsgrad über 10% ergab. Dies stellt einen bedeutsamen technischen Fortschritt dar, da die erhebliche Kostensenkung den Einsatzbereich des Massenproduktes erweitert. Bisher war weder in Betracht gezogen worden, noch gar für möglich gehalten worden, daß mit Fensterglas nicht nur funktions- sondern in ernst zu nehmender Weise einsatzfähige Solarzellen dieser Art hergestellt werden können.

Ferner wurde gefunden, daß bei einer solchen Temperatursteuerung des Substrats mit einer hohen CdTe-Abscheiderate zwischen 5 bis 15 µm/min gearbeitet werden konnte und hierbei das Wachstum der CdTe-Schicht von anfang an bei einer für die Erreichung der erforderlichen (photo)elektronischen Eigenschaften derart günstigen Temperatur stattfindet, daß ebenfalls ein guter Wirkungsgrad der Zelle erzielbar ist. Derartig hohe Abscheideraten sind weder in Sauerstoff noch in Inertgasen bisher möglich gewesen.

Vorzugsweise wird erfindungsgemäß folgendermaßen vorgegangen. Es wird als transparentes Substratmaterial kostengünstiges Standard-Natron-Kalk-Glas ("Fensterglas") verwendet, das mit einer transparenten, elektrisch leitfähigen (TCO)-Schicht (Transparent Conducting Oxid) belegt wird. (Diese besteht z.B. aus einer geeigneten, dotierten Zinnoxidschicht, beispielsweise aus ITO oder einer modifizierten ITO-Schicht). Die TCO-Schicht stellt gleichzeitig den elektrischen Frontkontakt der Solarzelle dar. Darauf wird im Hochvakuum bei ca. 150 °C eine dünne CdS-Schicht (Dicke etwa 80 bis 120 nm, vorzugsweise 100 nm) aufgedampft, deren Dotierung vorzugsweise in weiter unten aufgezeigter Weise erzielt wird.

Anschließend erfolgt direkt auf die CdS-Schicht die Abscheidung der photoaktiven CdTe-Schicht nach den Kleindistanz(CSS)-Verfahren ("Close-Spaced Sublimation"). Das die CdS-Schicht tragende Substrat wird dabei in einem stetigen Anheizprozeß (ohne Unterbrechung) in vorzugsweise etwa 3 min auf eine Temperatur von 480 bis 520 °C, vorzugsweise 500 °C, gebracht. Die TCO-Schicht erleidet im Laufe dieser kurzen Anheizphase keine Beeinträchtigung, da sie durch die CdS-Schicht geschützt ist. Während dieser Zeit erreicht die CdTe-Quelle eine Temperatur, bei der noch keine merkliche Sublimation des CdTe stattfindet. Erst wenn die Substrattemperatur (nach z.B. den 3 min) 480 bis 520 °C, vorzugsweise 500 °C, erreicht hat, wird die CdTe-Quelle in etwa 1 min auf eine solche Temperatur (z.B. im Bereich von 700 bis etwa 770 °C, vorzugsweise um 740 °C) gebracht, bei der auf der CdS-Schicht eine CdTe-Abscheiderate von 5 bis 15 µm/min, vorzugsweise um 10 µm/min, erreicht wird und damit die erforderliche CdTe-Schicht von 5 bis 10 µm Dicke in der kurzen Zeit von etwa 1 min erzeugt werden kann.

Während der CdTe-Abscheidung wird in der Reaktionskammer (Quarzrohr) vorzugsweise ein Druck von ca 0,1 mbar Stickstoff (oder ähnlichen inerten Gasen wie Helium, Argon oder Wasserstoff) dadurch aufrechterhalten, das in Form eines dynamischen Gleichgewichts über verschiedene Anschlüsse der Reaktionskammer gleich viel Gas zugeführt wie abgepumpt wird.

Die CdTe-Quelle, von der das auf der CdS-Schicht abzuscheidende Material absublimiert befindet sich dabei vorzugsweise im geringen Abstand von nur etwa 2 bis 3 mm gegenüber der Substratfläche. Aufgrund des geringen Abstandes von Substrat und CdTe-Quelle sowie ihrer direkten Gegenüberstellung wird eine nahezu 100%ige Ausnutzung des CdTe-Ausgangsmaterials erreicht. Weiterhin tragt die erfindungsgemäß mögliche geringe Dicke der CdTe-Schicht zu einem kostengünstigen Umgang mit dem wertvollen Halbleitermaterial bei. Auch die kurze Abscheidezeit wirkt sich bei diesem Verfahrensablauf kostengünstig aus.

Während des beschriebenen Vorganges der CdTe-Abscheidung werden das Substrat und die CdTe-Quelle vorzugsweise in gegenüberliegenden Graphitblöcken gehaltert, die mit Heizelementen (z.B. Halogenlampen) geheizt werden, um die jeweils notwendigen Temperaturen zu erzeugen. Letztere werden durch eine geeignete manuelle oder rechnergesteuerte Regelung der Heizleistung der Heizelemente eingestellt. Die CdCl₂-Temperung, die im Anschluß an die CdTe-Beschichtung durchgeführt wird, ist an sich bekannt.

Die erfindungsgemäße Weiterbildung des Verfahrens gemäß Anspruch 10 beruht auf den im folgenden dargelegten Zusammenhängen. Auch sie trägt wesentlich dazu bei, das Verfahren für die Massenproduktion deutlich zu verbessern, indem die Dotierung der CdS-Schicht verfahrensmäßig erheblich erleichtert ist. Zudem ist es möglich, auch durch diese Maßnahme auch den Wirkungsgrad der fertigen Solarzelle zu erhöhen.

Schließlich kann im Gegensatz zu den bekannten kritischen Sauerstoffdotierungen ohne Gefährdung der CdTe-Quelle durch Oxidation während der CdTe-Beschichtung mit hohem Druck gearbeitet werden.

Förderlich für das Erreichen eines günstigen Wirkungsgrades der pn CdTe/CdS-Dünnschichtsolarzelle ist ein n-Typ CdS mit hoher Leitfähigkeit von der Größenordnung 0,1 S/cm. Während eine bei ca. 150 °C hergestellte CdS-Schicht diese Bedingung gut erfüllt, zeigt eine einem thermischen Prozeß wie bei der CdTe-Abscheidung unterzogene CdS-Schicht nur noch eine sehr kleine Leitfähigkeit von <10⁻⁵ S/cm. Um bei der Leitfähigkeit des CdS auch nach der thermischen Belastung der CdTe-Abscheidung eine wünschenswerte Größenordnung von 0,1 S/cm zu erhalten, wird eine ultradünne Indiumschicht einer Dicke von etwa 0.1 bis 0,5 nm. vorzugsweise um 0,2 nm, im Hochvakuum bei etwa 25 °C auf die TCO-Schicht aufgebracht, bevor die CdS-Schicht vorzugsweise in der oben angegebenen Weise aufgetragen wird. Die Dicke der Indiumschicht wird derart abgestimmt, daß die Diffusion des Indiums in die CdS-Schicht während der CdTe-Abscheidung bei vorgegebener Substrattemperatur, die vorzugsweise zwischen 480 und 520 °C liegt, eine solche n-Typ-Dotierung im CdS erzeugt, daß der Wert der Leitfähigkeit in der notwendigen Größenordnung von 0,1 S/cm erhalten bleibt. Die erforderliche und gewünschte n-Typ-Dotierung der CdS-Schicht erfolgt damit kostengünstig ohne zusätzlichen Aufwand während der CdTe-Abscheidung. Es ist darauf hinzuweisen, daß bereits ohne die Indiumdotierung der CdS-Schicht Wirkungsrade von um und über 10% erreicht wurden, wenn wie im Anspruch 1 angegeben vorgegangen wird.

Nach der allgemein üblichen CdCl₂-Temperung (R.W. Birkmire et al, Proc. Polycrystalline Thin Film Programm Meeting, Lakewood, Colorado, USA, (1989) 77-84) wird auf die CdTe-Schicht eine etwa 5 bis 10 nm dicke Goldschicht als Rückkontakt aufgedampft. Zur Vermeidung eines Serienwiderstandes wird die Goldschicht vorzugsweise mit einem kostengünstigen Metall (z.B. Aluminium) bedampft (ca. 100 - 200 nm) bzw. mit einer leitfähigen Paste bestrichen und damit auf die für die Ableitung des Photostroms notwendige Leitfähigkeit gebracht.

Die Beleuchtung der Solarzelle erfolgt durch das transparente Glassubstrat.

Die Maßnahme der speziellen erfindungsgemäßen CdS-Schicht-Dotierung wird vorzugsweise mit den anderen erfindungsgemäßer Merkmalen kombiniert. So kann bei den erfindungsgemäß gesteuerten Substrattemperaturen die Vermischung der CdS-Schicht und der Indiumschicht gut erzielt werden. Bei Kombination mit der ebenfalls möglichen schnellen Abscheiderate werden die Effizienz des Verfahrens und seine Eignung für die Massenproduktion weiter verbessert.

Die erfindungsgemäßen Merkmale fördern somit für sich genommen und in ihrer Kombination die kostengünstige Massenproduktion der in Frage stehenden vom prinzipiellen Aufbau her bekannten pn CdTe/CdS-Dünnschichtsolarzellen. Es sind preiswerte Substratmaterialien möglich und es sind hohe Ausbeuten der teuren Halbleitermaterialien bei hohen Abscheideraten für die Halbleiterschichten erzielbar. Der bisher häufig kritische Dotierungsschritt ist deutlich verbessert und rationalisiert. Zudem tragen die genannten Maßnahmen zur Erzielung eines hohen Wirkungsgrades bei. Somit schaffen die erfindungsgemäßen Merkmale einen wichtigen Schritt zu einer alternativen Energieversorgung über Solarzellen, die sowohl die Massenproduktion als einen hohen Wirkungsgrad der Zellen bedingt.

Im folgenden wird die Erfindung anhand der Zeichnungen weiter erläutert.
Es zeigen:
- Fig. 1: in schematischer Darstellung einen Schnitt durch eine nach einem bevorzugten Ausführungsbeispiel des erfindungsgemäßen Verfahren hergestellte pn CdTe/CdS-Dünnschichtsolarzelle,
- Fig. 2: in schematischer Darstellung einen Schnitt durch eine für die Durchführung des erfindungsgemäßen Verfahrens geeignete Apparatur,
- Fig. 3: die Strom/Spannungs-Kennlinie einer nach dem anhand Fig.1 erläuterten Verfahren hergestellten pn CdTe/CdS-Dünnschichtsolarzelle und
- Fig. 4: den Verlauf der (externen) absoluten Quantenausbeute in Abhängigkeit von der Wellenlänge einer nach dem anhand Fig.1 erläuterten Verfahren hergestellten pn CdTe/CdS-Dünnschichtsolarzelle.

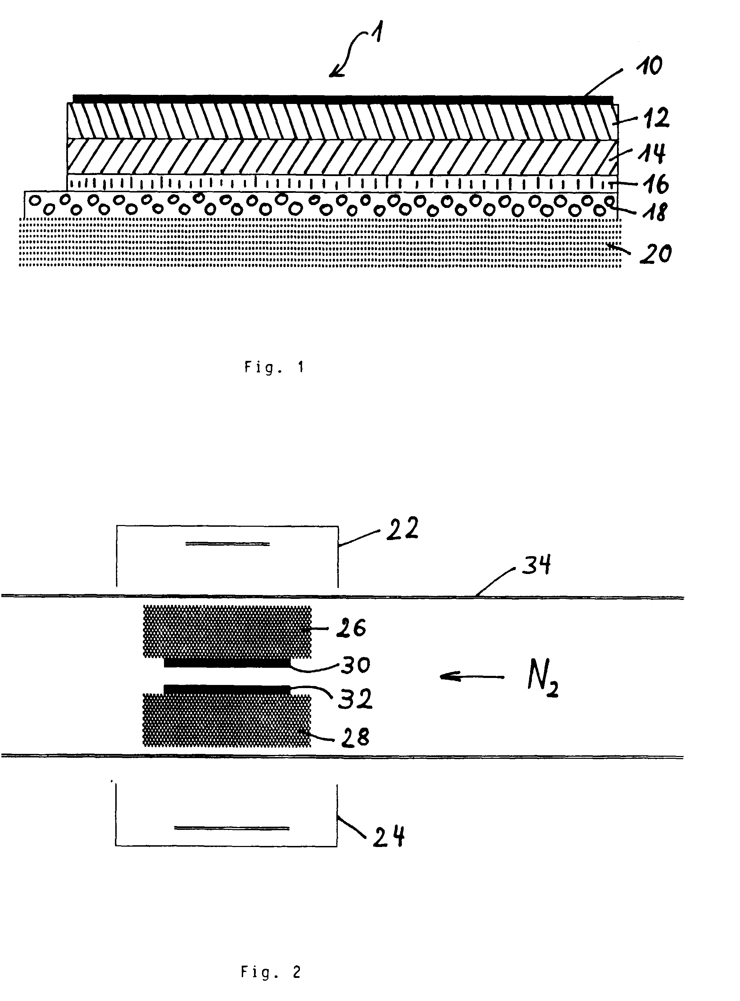

Die Fig.1 zeigt einen schematischen Schnitt durch eine pn cdTe/cds-Dünnschichtsolarzelle 1, die nach einem bevorzugten Ausführungsbeispiel des erfindungsgemäßen Verfahren hergestellt worden ist. Das transparente Substrat 20 besteht aus Natron-Kalk-Glas ("Fensterglas") und ist mit einer transparenten, elektrisch leitfähigen TCO-Schicht 18 beschichtet. Daran schließen eine ultradünne Indiumschicht 16 und eine CdS-Schicht 14 (z.B. 0,10 µm dick) an. Die dann folgende photoaktive CdTe-Schicht 12 wird (vorzugsweise um 5µm dick, jedoch in der Dicke nicht kritisch für die Gesamtzelle, solange man über 2 bis 3 µm bleibt,) gemäß der oben gegebenen Erläuterungen auf der CdS-Schicht abgeschieden. Wie außerdem dargelegt wurde, vermischen sich dabei die Schichten 16 und 14 derart, daß die Indiumschicht 16 sich infolge der Diffusion der Indiumatome in die Schicht 14 auflöst und in der fertigen Solarzelle 1 als solche nicht mehr identifizierbar ist. Die CdS-Schicht 14 enthält somit nach der Herstellung die Indiumatome der Indiumschicht 16 in verteilter Form als gewünschte und notwendige n-Typ-Dotierung.

Diese während der Abscheidung der CdTe-Schicht 12 gleichzeitig erfolgende n-Typ-Dotierung der CdS-Schicht 14 stellt einen weiteren Fortschritt sowohl in Bezug auf die bessere Eignung des Verfahrens für eine kostengünstige Massenproduktion als auch die Schaffung einer Solarzelle mit hohem Wirkungsgrad dar. Die etwa 0,1 bis 0.5 nm dicke und verzugsweise im m Hochvakuum bei etwa 25 °C aufgedampfte Indiumschicht 16 ist während des Verfahrensablaufes als solche also nur bis zu dem Verfahrensschritt vor der CdTe-Abscheidung identifizierbar.

Nach dem Abschluß der CdTe-Abscheidung erfolgt nach der oben angegebenen CdCl₂-Temperung die Aufbringung eines elektrisch leitfähigen Metallkontaktes 10 auf die CdTe-Schicht 12, der als Rückkontakt der Solarzelle 1 dient. Als Frontkontakt der Solarzelle 1 fungiert die TCO-Schicht 18. Die Beleuchtung der Solarzelle 1 erfolgt durch das Glassubstrat 20 und die TCO-Schicht 18.

Von besonderer Bedeutung ist auch der CdTe-Abscheidevorgang. In Fig. 2 ist eine vorzugsweise zu verwendende Reaktionskammer, ebenfalls in schematischem Querschnitt, dargestellt. Diese besteht aus einem Quarzreaktor 34 und Graphitblöcken 26 und 28 sowie Heizelementen (z.B. Halogenlampen) 22 und 24, mit denen die Graphitblöcke 26 und 28 geheizt werden. Das Glassubstrat 20 mit der TCO-Schicht 18 sowie der Indiumschicht 16 und der CdS-Schicht 14, dargestellt als Element 30 in Fig. 2, wird am oberen Graphitblock 26 derart befestigt, daß das Glassubstrat 20 am Graphitblock 26 anliegt und die CdS-Schicht 14 zur CdTe-Quelle gerichtet ist. Die CdTe-Quelle 32, z.B. in Form einer polykristallinen Scheibe, befindet sich auf dem unteren Graphitblock 28. Anstelle einer polykristallinen Scheibe als CdTe-Quelle 32 läßt sich selbstverständlich auch ein aus CdTe-Pulver hergestellter Preßling bzw. eine Vorrichtung mit CdTe-Pulver verwenden.

Die CdTe-Abscheidung erfolgt in der Reaktionskammer 34 nach einem Verfahrensablauf, bei dem wie oben bereits ausführlich erläutert, entscheidend ist, daß der zeitliche Verlauf der Temperatur von Element 30 und CdTe-Quelle 32 derart geführt wird, daß das die CdS-Schicht beinhaltende Element 30 in einem stetigen Anheizprozeß (ohne Unterbrechung) in z.B. 3 min auf eine Temperatur von 480 - 520 °C, vorzugsweise 500 °C, gebracht wird, wobei die TCO-Schicht 18 im Laufe dieser kurzen Anheizphase keine Beeinträchtigung erleidet, da sie durch die CdS-Schicht 14 geschützt ist. Während dieser Zeit erreicht die CdTe-Quelle 32 eine Temperatur, bei der noch keine merkliche Sublimation des CdTe stattfindet. Erst wenn die Temperatur des Elementes 30 480 bis 520 °C, vorzugsweise 500 °C, erreicht hat, wird die CdTe-Quelle 32 in ca. 1 min auf eine solche Temperatur gebracht, daß auf der CdS-Schicht 14 eine CdTe-Abscheiderate von 5 bis 15 µm/min, vorzugsweise ≈10 µm/min, erreicht wird und damit die erforderliche CdTe-Schicht 12 von 5 bis 10 µm Dicke in der kurzen Zeit von etwa 1 min erzeugt werden kann. Diese Verfahrensführung bewirkt, daß das Wachstum der CdTe-Schicht 12 von anfang an bei einer für die Erreichung der notwendigen (photo)elektronischen Eigenschaften günstigen Temperatur stattfindet. Die Temperatur des Elementes 30 ist so gewählt, daß billiges Natron-Kalk-Glas als Material für das Substrat 20 eingesetzt werden kann. Der Druck in der Reaktionskammer 34 beträgt während der CdTe-Abscheidung ca. 0,1 mbar und wird durch Zuströmen bzw. Abpumpen von Stickstoff (oder Helium, Argon oder Wasserstoff) aufrechterhalten.

Die Heizleistung der Heizelemente 22 und 24 kann wahlweise manuell oder rechnergesteuert variiert werden.

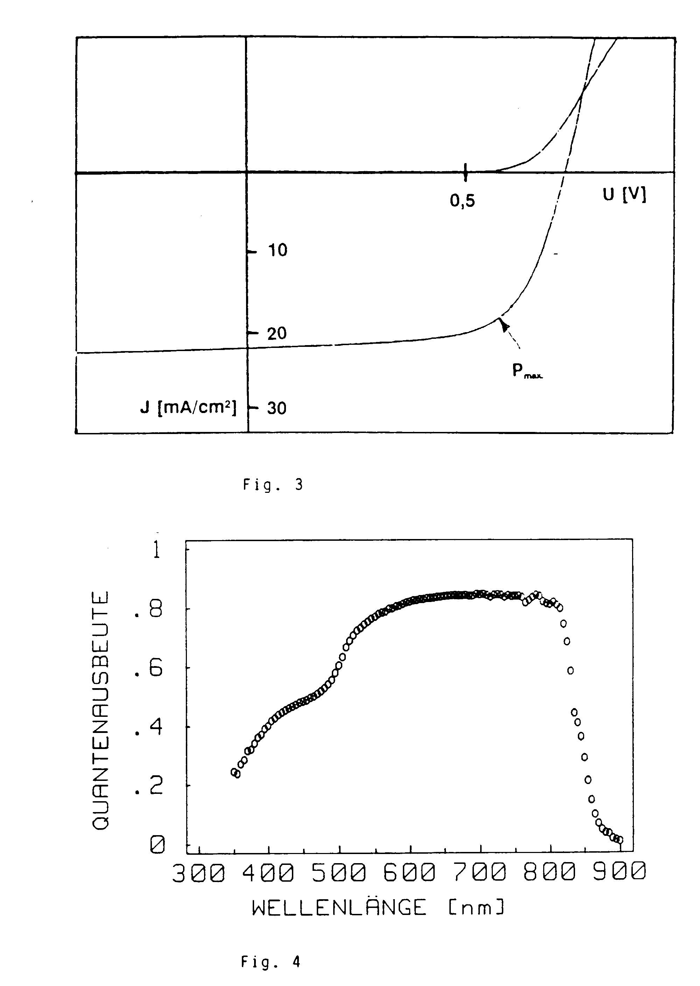

In Fig. 3 und Fig. 4 sind die Strom/Spannungs-Kennlinie bzw. die (externe) absolute Quantenausbeute in Abhängigkeit von der Wellenlänge einer nach dem obigen Verfahren hergestellten pn CdTe/CdS-Dünnschichtsolarzelle wiedergegeben. Wie aus Fig. 3 zu ersehen ist, beträgt die Kurzschlußstromdichte für die hergestellte Solarzelle bei einer Leerlaufspannung von 0,750 V und einem Füllfaktor von 65,0%, 22,8 mA/cm². Die aktive Flache der Solarzelle des vorgestellten Ausführungsbeispiels beträgt 0,388 cm². Damit ergibt sich ein Wirkungsgrad von 11,0% (bezogen auf eine Beleuchtung mit 100 mW/cm² AM1,5 global).

Die (externe) absolute Quantenausbeute zeigt gemäß Fig. 4 über den wesentlichen Teil (ca. 820 - 520 nm) des Spektrums einen konstanten Verlauf mit einem Wert um 85%. Der Abfall bei 520 nm wird durch die Absorption in der CdS-Schicht 14 bewirkt.

## Patentansprüche

1. Verfahren zur Herstellung einer pn CdTe/CdS-Dünnschichtsolarzelle, in welchem ein transparentes Substrat mit einer transparenten, elektrisch leitfähigen TCO-Schicht als Frontkontakt und einer n-dotierten CdS-Schicht versehen wird, auf der nach dem Close-Spaced-Sublimation-Verfahren eine CdTe-Schicht in einer Inertgasatmosphäre abgeschieden wird, die mit einem elektrisch leitenden Rückkontakt versehen wird,
dadurch gekennzeichnet,
daß als Substrat ein aus Standard-Natron-Kalk-Glas in Form von Fensterglas bestehendes Substrat verwendet wird und daß mit der TCO-Schicht (18) und der CdS-Schicht (14) versehene Substrat (20) vor der CdTe-Beschichtung auf eine Temperatur zwischen etwa 480°C bis 520°C gebracht wird, die während der folgenden CdTe-Beschichtung beibehalten wird.

2. Verfahren nach Anspruch 1.
dadurch gekennzeichnet,
daß nach der CdTe-Beschichtung eine CdCl₂-Temperung angewandt wird.

3. Verfahren nach Anspruch 1 oder 2,
dadurch gekennzeichnet,
daß das mit der TCO-Schicht (18) und der CdS-Schicht (14) versehene Substrat (20) vor der CdTe-Beschichtung auf eine Temperatur von etwa 500 °C gebracht wird, die während der folgenden CdTe-Beschichtung beibehalten wird.

4. Verfahren nach einem der vorhergehenden Ansprüche,
dadurch gekennzeichnet,
daß die Aufheizung des mit der TCO-Schicht (18) und der CdS-Schicht (14) versehenen Substrats (20) in einem stetigen Anheizprozeß zwischen etwa 1 bis etwa 5 min, vorzugsweise in etwa 3 min, erfolgt.

5. Verfahren nach Anspruch 4,
dadurch gekennzeichnet,
daß die Aufheizung in etwa 3 min durchgeführt wird.

6. Verfahren nach einem der vorhergehenden Ansprüche,
dadurch gekennzeichnet,
daß die CdTe-Abscheiderate auf der CdS-Schicht (14) auf etwa 5 bis 15 µm/min eingestellt wird.

7. Verfahren nach Anspruch 6,
dadurch gekennzeichnet,
daß die CdTe-Schicht (12) in etwa 1 min abgeschieden wird.

8. Verfahren nach Anspruch 6 oder 7,
dadurch gekennzeichnet,
daß die CdTe-Abscheiderate auf 10 µm/min eingestellt wird.

9. Verfahren nach einem der Vorhergehenden Ansprüche,
dadurch gekennzeichnet,
daß der zeitliche Verlauf der Temperatur des mit der TCO-Schicht (18) und der CdS-Schicht (14) versehenen Substrats (20) und der CdTe-Quelle (32) derartig gesteuert wird, daß das Substrat (20) mit der CdS-Schicht (14) und der TCO-Schicht (18) in einem stetigen Anheizprozeß in etwa 1 bis 5 min auf eine Temperatur von 480 bis 520 °C gebracht wird und während dieser Zeit die verwendete CdTe-Quelle (32) auf eine Temperatur gebracht wird, bei der noch keine merkliche Sublimation des CdTe stattfindet, und daß erst wenn die Temperatur des Substrats mit den beiden Schichten die gewünschte Temperatur zwischen 480 bis 520 °C erreicht hat, die CdTe-Quelle (32) in etwa 1 min auf eine Temperatur gebracht wird, bei der auf der CdS-Schicht (14), eine CdTe-Abscheiderate erzielt wird, mit der die erforderliche CdTe-Schicht (12) in einer Zeitspanne von etwa 1 min aufgebracht werden kann.

10. Verfahren nach einem der vorhergehenden Ansprüche,
dadurch gekennzeichnet,
daß zur n-Dotierung der CdS-Schicht (14) Indium verwendet wird und daß vor Abscheidung der CdS-Schicht (14) eine ultradünne Indiumschicht (16) von weniger als 0,5 nm Dicke auf die TCO-Schicht (18) aufgebracht wird und daß sich während der Abscheidung der CdTe-Schicht (12) die In-Schicht (16) und die CdS Schicht (14) derart mischen, daß die Indiumschicht (16) sich infolge der Diffusion der Indiumatome in die CdS-Schicht (14) auflöst und in der fertigen Solarzelle !1) als solche nicht mehr identifizierbar ist und die CdS-Schicht (14) nach der Fertigstellung der Solarzelle (1) die Indiumatome der Indiumschicht (16) in verteilter Form als n-Dotierung enthält.

## Claims

1. A method of making a pn CdTE/CdS thin film solar cell, in which a transparent substrate is provided with a transparent, electrically conducting TCO layer as front contact and an n-doped CdS layer, on which a CdTe layer is deposited in an inert atomosphere according to the close-spaced sublimation method and is provided with an electrically conducting back contact,
**characterized in that,**
a substrate consisting of standard-soda-lime glass in form of window glass is used as substrate and the substrate (20) provided with the TCO layer (18) and the CdS layer (14) is brought to a temperature between approximately 480° C to 520° C before coating with the CdTe layer, said temperature being maintained during the following CdTe coating.

2. A method according to claim 1,
**characterized in that**
a CdCl₂ tempering known per se is employed after the CdTe coating.

3. A method according to claim 1 or 2,
**characterized in that**,
the substrate (20) provided with the TCO layer (18) and the CdS layer (14) is brought to a temperature of about 500° C before the CdTE coating, which temperature is maintained during the following CdTE coating.

4. A method according to any of the preceding claims,
**characterized in that**
the heating of the substrate (20) provided with the TCO layer (18) and the CdS layer (14) is effected in a steady heating process over between approximately 1 to approximately 5 min., preferably over approximately 3 min.

5. A method according to claim 4,
**characterized in that**
the heating is effected in approximately 3 min.

6. A method according to any of the preceding claims,
**characterized in that**
the deposition rate of the CdTE on the CdS layer (14) is adjusted to approximately 5 to 15 um/min.

7. A method according to claim 6,
**characterized in that**
the CdTe layer (12) is deposited in approximetaley 1 min.

8. A method according to claim 6 or 7,
**characterized in that**
the deposition rate of the CdTe is adjusted to approximately 10 um/min.

9. A method according to any of the preceding claims,
**characterized in that**
the variation with time of the temperature of the substrate (20) provided with the TCO layer (18) and the CdS layer (14) and of the CdTe source (32) is controlled such that the substrate (20) with the CdS layer (14) and the TCO layer (18) is brought in a steady heating process to a temperature of 480 to 520° C in approximately 1 to 5 min. and, during this time, the CdTe source (32) employed is brought to a temperature at which there is still not appreciable sublimation in the CdTE, and in that, only when the temperature of the substrate with the two layers has attained the desired temperature between 480 and 520° C, the CdTe source (32) is brought in approximately 1 min. to a temperature at which a CdTe deposition rate on to the CdS layer (14) is obtained such that the required CdTe layer (12) can be applied in an interval of time of approximately 1 min.

10. A method according to any of the preceding claims,
**characterized in that,**
indium is used for the n-doping of the CdS layer (14) and in that, before the deposition of the CdS layer (14) an ultrathin indium layer (16) less than 0.5 nm thick is applied to the TCO layer (18) and in that the In and CdS layers (16) and (14) so mix during the deposition of the CdTE layer (12) that the indium layer (16) is dissolved by diffusion of the indium atoms into the CdS layer (14) and is no longer identifiable as such in the finished solar cell (1) and the CdS layer (14) includes the indium atoms of the indium layer (16) in dispersed form as n-doping after finishing the solar cell (1).

## Revendications

1. Procédé de fabrication d'une cellule solaire à couche mince du type pn CdTe/CdS, dans lequel un substrat transparent est pourvu d'une couche de TCO conductrice électrique, transparente, en tant que contact frontal, et d'une couche de CdS dopée n, sur laquelle est déposée une couche de CdTe, par le procédé de " Close-Spaced Sublimation " dans une atmosphère de gaz inerte, laquelle est munie d'un contact arrière conducteur électrique, caractérisé en ce que
le substrat utilisé est un substrat constitué par un verre calcaire natron standard sous forme de verre à vitre et en ce que le substrat pourvu de la couche de TCO (18) et de la couche CdS (14) est, avant d'être pourvu de la couche CdTe, porté à une température comprise entre 480 °C et 520 °C environ, qui est maintenue pendant le processus de revêtement de CdTe consécutif.

2. Procédé selon la revendication 1, caractérisé en ce qu'un recuit de CdCl₂ est appliqué à la suite du processus de revêtement CdTe.

3. Procédé selon la revendication 1 ou 2, caractérisé en ce que le substrat (20) pourvu de la couche de TCO (18) et de la couche de CdS (14) est, avant d'être pourvu de la couche de CdTe, porté à une température de 500 °C environ, qui est maintenue pendant le processus de revêtement de CdTe consécutif.

4. Procédé selon l'une des revendications précédentes, caractérisé en ce que l'étape de chauffage du substrat (20) pourvu de la couche de TCO (18) et de la couche de CdS (14) se produit au cours d'un processus de chauffage régulier en 1 à 5 minutes environ, de préférence en 3 minutes environ.

5. Procédé selon la revendication 4, caractérisé en ce que le chauffage est effectué en trois minutes environ.

6. Procédé selon l'une des revendications précédentes, caractérisé en ce que le taux de déposition de CdTe sur la couche de CdS (14) est réglé de 5 à 15 µm/min environ.

7. Procédé selon la revendication 6, caractérisé en ce que la couche de CdTe (12) est déposée en une minute environ.

8. Procédé selon la revendication 6 ou 7, caractérisé en ce que le taux de déposition de CdTe est réglé sur 10 µm/min.

9. Procédé selon l'une des revendications précédentes, caractérisé en ce que l'évolution en fonction du temps de la température du substrat (20), pourvu de la couche de TCO (18) et de la couche de CdS (14), et de la source de CdTe (32) est régulée de telle sorte que le substrat (20), ainsi que les couches de revêtement de TCO (18) et de CdS (14), sont portés, en l'espace de 1 à 5 mn environ, à une température comprise entre 480 °C et 520 °C, au cours d'un processus de chauffage régulier, et pendant ce temps, la source de CdTe (32) utilisée est portée à une température à laquelle ne se produit pas encore une sublimation sensible de CdTe, et en ce que, seulement lorsque la température du substrat avec les deux couches a atteint la température souhaitée entre 480 °C et 520 °C, la source de CdTe (32) est portée, dans un intervalle de temps de 1 mn environ, à une température à laquelle le taux de déposition de CdTe, obtenu sur la couche de CdS (14), permet de déposer dans un intervalle de temps d'environ 1 mn l'épaisseur de couche CdTe (12) requise.

10. Procédé selon l'une des revendications précédentes, caractérisé en ce que de l'indium est utilisé pour le dopage n de la couche de CdS (14) et qu'une couche ultramince d'indium (16) d'une épaisseur inférieure à 0,5 nm est appliquée sur la couche de TCO (18) avant la déposition de la couche de CdS (14) et que pendant la déposition de la couche de CdTe (12), la couche d'indium (16) et la couche de CdS (14) se mélangent de telle façon que la couche d'indium (16) se dissout à la suite de la diffusion des atomes d'indium dans la couche de CdS (14) et n'est plus identifiable en tant que tel dans la cellule solaire produite (1) et qu'après la fabrication de la cellule solaire (1), la couche de CdS (14) contient sous forme répartie les atomes d'indium de la couche d'indium (16) comme dopage n.
